Europäisches Patentamt

European Patent Office

Office européen des brevets

(11) Veröffentlichungsnummer: **0 525 625 A1**

## EUROPÄISCHE PATENTANMELDUNG

(21) Anmeldenummer: **92112559.7**

(22) Anmeldetag: **22.07.92**

(51) Int. Cl.⁵: **G03F 7/029**

(30) Priorität: **29.07.91 DE 4125042**

(43) Veröffentlichungstag der Anmeldung:
**03.02.93 Patentblatt 93/05**

(84) Benannte Vertragsstaaten:
**BE CH DE FR GB IT LI**

(71) Anmelder: **HOECHST AKTIENGESELLSCHAFT
Postfach 80 03 20
W-6230 Frankfurt am Main 80(DE)**

(72) Erfinder: **Pawlowski, Georg, Dr.
Fritz-Kalle-Strasse 34
W-6200 Wiesbaden(DE)**
Erfinder: **Dammel, Ralph, Dr.
70 Wood Cove Drive, Wood Estates
Coventry, Rhode Island 02816(US)**
Erfinder: **Röschert, Horst, Dr.
Am Pfingstborn 16
W-6531 Ober Hilbersheim(DE)**
Erfinder: **Meier, Winfried, Dipl.-Ing.
Am Brennhaus 19
W-6230 Frankfurt am Main 80(DE)**
Erfinder: **Spiess, Walter, Dr.
Rheingaustrasse 20
W-6110 Dieburg(DE)**
Erfinder: **Przybilla, Klaus-Jürgen, Dr.
Beethovenstrasse 19
W-6000 Frankfurt am Main 1(DE)**

(54) **Negativ arbeitendes strahlungsempfindliches Gemisch und damit hergestelltes strahlungsempfindliches Aufzeichnungsmaterial.**

㊗ Die Erfindung betrifft ein negativ arbeitendes strahlungsempfindliches Gemisch mit

a) einer Verbindung, die mindestens eine -CBr₃ Gruppe, gebunden an ein Atom, das nicht seinerseits mit einem Wasserstoffatom verbunden ist,

b) einem alkoxymethylierten Melamin und

c) einem in Wasser unlöslichen, in wäßrig-alkalischen Lösungen löslichen oder zumindest quellbaren polymeren Bindemittel mit phenolischen OH-Gruppen,

das dadurch gekennzeichnet ist, daß

(1) es bei 248 nm eine Absorption < 0,4 $\mu m^{-1}$ aufweist,

(2) die CBr₃-Gruppe der Verbindung a) an das Schwefelatom einer Sulfonylgruppe gebunden und die Verbindung a) in einer Menge von 0,2 bis 10 Gew.-%, bezogen auf die Gesamtmenge der Komponenten b) und c), im Gemisch enthalten ist,

(3) das Massenverhältnis der Komponenten b) und c) zwischen 50 : 50 und 5 : 95 liegt und

(4) die Komponente c) ein Homo- oder Copolymer des Hydroxystyrols oder eines Derivats davon ist, wobei das Homo- oder Copolymer in einem wäßrig-alkalischen, 2,38 Gew.-% Tetramethylammoniumhydroxid enthaltenden Entwickler bei 21°C eine Abtragsrate von 200 bis 3000 nm/min aufweist.

Die Erfindung betrifft ein negativ arbeitendes strahlungsempfindliches Gemisch mit

a) einer Verbindung, die mindestens eine -CBr$_3$ Gruppe, gebunden an ein Atom, das nicht seinerseits mit einem Wasserstoffatom verbunden ist, enthält und unter Einwirkung aktinischer Strahlung starke Säure bildet,

b) einer Verbindung mit mindestens zwei durch Säure vernetzbaren Gruppen und

c) einem in Wasser unlöslichen, in wäßrig-alkalischen Lösungen löslichen oder zumindest quellbaren polymeren Bindemittel mit phenolischen OH-Gruppen.

Die Erfindung betrifft weiterhin ein damit hergestelltes strahlungsempfindliches Aufzeichnungsmaterial, das insbesondere zur Herstellung von Photoresists, aber auch zur Fertigung von elektronischen Bauteilen, Druckplatten oder zum Formteilätzen geeignet ist.

Zur Herstellung mikroelektronischer Schaltungen finden derzeit mehrere lithographische Techniken Anwendung. Mit der g-line-Lithographie (436 nm), die üblicherweise auf konventionelle positiv arbeitende Diazonaphthochinon/Novolak-Formulierungen angewendet wird, können Resistbilder mit einer Auflösung von bis zu 0,8 $\mu$m hergestellt werden. Noch feinere Strukturen (bis herab zu 0,5 $\mu$m) lassen sich vorteilhaft mit Hilfe der i-line-Lithographie (365 nm) auf einer Resistschicht abbilden. Neuere Modifikationen der i-line-Lithographie, wie beispielsweise die Phase-Shifting-Mask-Technologie erlauben eine weitere Verkleinerung der abzubildenden Strukturen bis herab zu etwa 0,4 $\mu$m oder kleiner. Eine noch höhere Auflösung läßt sich mit UV2-Photoresists erreichen. Dabei werden zwei Bestrahlungstechniken eingesetzt: die UV2-Breitband-Belichtung (ca. 240 bis 260 nm) oder die Belichtung mit KrF-Excimer-Lasern, die bei 248 nm emittieren.

Die stetige Verkleinerung der Strukturen, beispielsweise in der Chip-Herstellung bis in den Bereich von weniger als 0,5 $\mu$m, erfordert veränderte lithographische Techniken, wobei auch negativ arbeitende Photoresiste für spezielle Anwendungen bevorzugt eingesetzt werden. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an neuen, insbesondere negativ arbeitenden strahlungsempfindlichen Gemischen, die in den neueren Technologien, wie der Deep-UV-Lithographie, [Belichtung z. B. mit Excimer-Lasern bei Wellenlängen von 248 nm (KrF), 193 nm (ArF)], der Elektronen- oder der Röntgenstrahl-Lithographie, einsetzbar sind.

Negativ arbeitende strahlungsempfindliche Gemische, die Bisazide als Vernetzer und von Isopren abgeleitete Bindemittel enthalten, sind bekannt. Sie werden als strahlungsempfindliche Schichten bei der Herstellung von Druckplatten, gedruckten Schaltungen und integrierten Schaltkreisen verwendet. Ihr Einsatz in der Mikrolithographie ist jedoch durch verschiedene technische Nachteile begrenzt. So ist es schwierig, qualitativ hochwertige Schichten ohne Fehlstellen (pin-holes) herzustellen. Der Wärmestand solcher Mischungen ist unzureichend, d. h. die Resistbilder werden bei der Verarbeitung durch thermischen Fluß verzerrt. Schließlich ist ihr Auflösungsvermögen auf Strukturen > 2 $\mu$m begrenzt, da sie bei der notwendigen Entwicklung mit organischen Lösemitteln auch in den gehärteten Bereichen unerwünscht hohe Quellung zeigen, was wiederum zu Strukturverzerrungen oder inhomogenen Entwicklungsprozessen und damit zu ungenauer Wiedergabe des durch die Belichtungsmaske vorgegebenen Bildes führt. Um Resistbilder mit einer Auflösung von besser als 2 $\mu$m herstellen zu können, sind andere negativ arbeitende strahlungsempfindliche Gemische entwickelt worden, die empfindlich gegenüber Strahlung kürzerer Wellenlänge sind, beispielsweise gegenüber energiereicher UV-, Elektronen- oder Röntgenstrahlung. Ein derartiges Gemisch enthält beispielsweise ein Copolymer aus (2,3-Epoxy-propyl)-methacrylat und (2,3-Dichlorpropyl)methacrylat (DCOPA) oder eine Kombination der entsprechenden Homopolymeren. Die Glasübergangstemperatur dieses Gemisches ist jedoch für viele Anwendungen zu niedrig, insbesondere ist aber die geringe Plasmaätzbeständigkeit des Gemisches zu bemängeln. Darüber hinaus muß auch dieses Resistmaterial mit Entwicklern auf der Basis von wenig umweltfreundlichen, organischen Lösemitteln verarbeitet werden. Eine geringe Plasmaätzbeständigkeit zeigen auch andere bisher bekannte negativ arbeitende Photoresists auf vorwiegend aliphatischer Basis.

In der EP-A 0 164 248 wurde ein säurehärtbares Gemisch beschrieben, das wäßrig-alkalisch entwickelbar ist, durch die Verwendung von Aromaten eine verbesserte Plasmaätzresistenz aufweist und gegenüber nahem UV-Licht (350 bis 450 nm) empfindlich ist. Als Säurebildner sind dabei insbesondere Sulfonsäureesterderivate des Diazonaphthochinons genannt worden, die bei der Belichtung schwach saure Carbonsäuren bilden und daher nur in vergleichsweise hoher Konzentration wirksam sind. Solche Gemische haben aber infolge der schwachen Absorptionen und des unzureichenden Ausbleichverhaltens des photolytischen Säurebildners eine geringe Empfindlichkeit für DUV-, Elektronen- und Röntgenstrahlung.

In der US-A 3,692,560 wird ein säurehärtbares Gemisch beschrieben, das ein säurevernetzbares Melaminderivat, einen Novolak und chlorierte Benzophenone als photolytische Säurebildner enthält. Auch diese Gemische haben im tiefen UV-Bereich keine ausreichende Empfindlichkeit. Säurehärtbare Gemische, die photolytisch gebildete Chlorwasserstoffsäuren als Vernetzungskatalysatoren aufweisen reagieren darüber hinaus häufig ungewöhnlich empfindlich auf geringste Änderungen in der Verarbeitungsweise, so daß ihr Einsatz in der Praxis begrenzt ist.

Das gleiche trifft für die in der EP-A 0 232 972 erwähnten säurebildenden Derivate des DDT's zu, die hochtoxisch sind und schon von daher nicht praxisgerecht sein können. Immerhin zeigen solche Verbindungen eine beachtliche Empfindlichkeit im tiefen UV-Bereich (200 bis 300 nm) und ergeben in Kombination mit im UV-Bereich transparenten Polyhydroxystyrolen strahlungsempfindliche Gemische mit relativ guten Wiedergabeeigenschaften. In der gleichen Patentschrift werden auch gewisse aliphatisch bromierte Cyanursäurederivate als photolytische Säurespender erwähnt. Da diese Verbindungen jedoch thermisch Bromwasserstoff eliminieren können, weisen diese enthaltende Gemische eine begrenzte Lagerfähigkeit auf.

Des weiteren wurden strahlungsempfindliche Gemische vorgeschlagen, die photolytische Säurespender enthalten, die bei der Belichtung organische Sulfonsäuren bilden. Beispiele sind die in der nicht vorveröffentlichten deutschen Patentanmeldung P 40 06 190.6 offenbarten Bissulfonyl- oder Carbonylsulfonyldiazomethane oder die in den nicht vorveröffentlichten Patentanmeldungen P 41 12 967.9, P 41 12 966.0 und P 41 12 965.2 beschriebenen N-Sulfonyloxygruppen enthaltenden Pyridone. Obwohl auch mit den dort aufgeführten Gemischen praxisnahe Ergebnisse erzielt werden können, gibt es einige Gründe, weshalb sie keine optimale Bildwiedergabe und Verarbeitung erlauben: Die in der nicht vorveröffentlichten deutschen Patentanmeldung P 40 06 190.6 genannten Bisarylsulfonyldiazomethane absorbieren relativ stark im tiefen UV2-Bereich, und gestatten es daher nicht, Resistmaterialien bereitzustellen, die gleichzeitig hochempfindlich sind und die Ausbildung orthogonaler Resistflanken bei kleinen Strukturen < 0,35 $\mu$m erlauben. Die in der gleichen Schrift genannten Carbonylsulfonyldiazomethane ergeben keine ausreichenden Säuremengen und die N-Sulfonyloxygruppen enthaltenden Pyridone sind verhältnismäßig starke Löslichkeitsinhibitoren, die eine ausreichende Löslichkeitsschere zwischen belichteten und unbelichteten Bereichen verhindern.

Weitere Verbindungen, die bei Bestrahlung mit energiereichem Licht eine starke Säure bilden, sind insbesondere Onium-Salze, wie Diazonium-, Phosphonium-, Sulfonium-und Jodonium-Salze von nicht nucleophilen Säuren, wie $HSbF_6$, $HAsF_6$, oder $HPF_6$ [J.V. Crivello, Polym. Eng. Sci., 23 (1983) 953]. Daneben sind Halogenverbindungen, insbesondere chromophor substituierte Trichlormethyltriazin-Derivate, Trichlormethyloxadiazol-Derivate, o-Chinondiazidsulfonylchloride und o-Chinondiazid-4-sulfonsäureester empfohlen worden.

Diese Verbindungen werden in negativ oder positiv arbeitenden strahlungsempfindlichen Gemischen verwendet. Die Verwendung solcher photolytischer Säurebildner bringt aber Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Ferner bilden die Oniumsalze bei der Photolyse sehr stark korrodierend wirkende Brønsted-Säuren. Diese Säuren greifen empfindliche Substrate an, so daß der Einsatz solcher Gemische zu unbefriedigenden Ergebnissen führt. Wie bereits früher erwähnt, bilden die Chlorverbindungen sowie die Chinondiazidsulfonsäurechloride Chlorwasserstoffsäuren mit den oben erwähnten Nachteilen. Solche Verbindungen besitzen darüber hinaus auf bestimmten Substraten nur eine begrenzte Haltbarkeit, die dadurch verbessert wurde, daß zwischen Substrat und strahlungsempfindlicher, Verbindungen des Typs a) enthaltender Schicht eine Zwischenschicht eingefügt wurde, was allerdings zu einer unerwünschten Zunahme von Defekten und zu einer verminderten Reproduzierbarkeit führte (DE-A 36 21 376 = US-A 4,840,867).

In neueren Arbeiten von F.M. Houlihan et al., SPIE 920, 67 (1988) wurden anhand positiv arbeitender Systeme gezeigt, daß neben den oben genannten Säurebildnern auch Nitrobenzylsulfonate, die bei Belichtung Sulfonsäuren mit geringer Wanderungstendenz bilden, in bestimmten säurelabilen Resistformulierungen verwendbar sind. Es kann aus diesen Ergebnissen abgeleitet werden, daß solche Verbindungen auch für photohärtbare Systeme verwendet werden können.

Trotz der bisher geleisteten intensiven Forschungstätigkeit auf diesem Gebiet ist derzeit kein strahlungsempfindliches Gemisch bekannt, das die oben beschriebenen Probleme und Nachteile nicht aufweist und mit dem sich ein negativ arbeitendes strahlungsempfindliches Aufzeichnungsmaterial herstellen läßt, das die eingangs beschriebenen vorteilhaften Eigenschaften miteinander zu kombinieren vermag.

Aufgabe der Erfindung war es daher, ein strahlungsempfindliches Gemisch bereitzustellen, das die eingangs beschriebenen Eigenschaften ohne die bekannten Nachteile miteinander verbindet.

Die Aufgabe wird gelöst durch ein negativ arbeitendes strahlungsempfindliches Gemisch mit

a) einer Verbindung, die mindestens eine -CBr$_3$ Gruppe, gebunden an ein Atom, das nicht seinerseits mit einem Wasserstoffatom verbunden ist, enthält und unter Einwirkung aktinischer Strahlung starke Säure bildet,

b) einer Verbindung mit mindestens zwei durch Säure vernetzbaren Gruppen und

c) einem in Wasser unlöslichen, in wäßrig-alkalischen Lösungen löslichen oder zumindest quellbaren polymeren Bindemittel mit phenolischen OH-Gruppen,

das dadurch gekennzeichnet ist, daß

(1) es bei 248 nm eine Absorption < 0,4 $\mu$m$^{-1}$ aufweist,

(2) die CBr$_3$-Gruppe der Verbindung a) an das Schwefelatom einer Sulfonylgruppe gebunden und die Verbindung a) in einer Menge von 0,2 bis 10 Gew.-%, bezogen auf die Gesamtmenge der Komponenten b) und c), im Gemisch enthalten ist,

(3) das Massenverhältnis der Komponenten b) und c) zwischen 50 : 50 und 5 : 95 liegt und

(4) die Komponente c) ein Homo- oder Copolymer des Hydroxystyrols oder eines Derivats davon ist, wobei das Homo- oder Copolymer in einem wäßrig-alkalischen, 2,38 Gew.-% Tetramethylammoniumhydroxid enthaltenden Entwickler bei 21°C eine Abtragsrate von 200 bis 3000 nm/min aufweist.

Die Verbindungen a) bilden unter Einwirkung von aktinischer Strahlung reaktive Zwischenstufen, die zur Einleitung spezieller chemischer Reaktionen, beispielsweise radikalischer Polymerisationen, befähigt sind. Sie bilden bei ihrer Bestrahlung jedoch insbesondere starke Säure, die Reaktionen, wie kationische Polymerisationen, Vernetzungen oder Spaltungen säurelabiler Verbindungen katalysieren oder mit Basen reagieren kann, was sich z. B. in einem Farbumschlag bei Indikatorfarbstoffen äußert.

Beispiele für Verbindungen a) sind insbesondere Tribrommethyl-aryl-sulfone, wie Tribrommethyl-phenyl-sulfon, Tribrommethyl-p-tolyl-sulfon, Tribrommethyl-(4-chlorphenyl)-sulfon und Tribrommethyl-(4-bromphenyl)-sulfon.

Eine ganz besonders bevorzugte Verbindung des Typs a) ist das Tribrommethyl-phenyl-sulfon. Die oben aufgeführten Verbindungen a) haben Absorptionsmaxima im Bereich zwischen 200 bis 250 nm und sind daher für eine Bestrahlung mit energiereicher UV-Strahlung im Bereich der UV2- (220 bis 280 nm) sehr gut geeignet.

Das erfindungsgemäße Gemisch zeigt eine hohe thermische und Plasmaätzbeständigkeit, hervorragende lithographische Eigenschaften, wie hohe Strahlungsempfindlichkeit, großen Verarbeitungsspielraum und exakte Bildwiedergabe auch kleinster Strukturen, was einer Auflösung im Sub-Halbmikrometer-Bereich entspricht. Man erhält nach dem bildmäßigen Bestrahlen und anschließendem Entwickeln ein detailgetreues Abbild der Maske. Die Resistfelder weisen orthogonale Flanken auf. In den bestrahlten Bereichen wird die Resistschicht bei Verwendung der üblichen wäßrig-alkalischen Entwickler, die 2,38 Gew.-% Tetramethylammoniumhydroxid enthalten, vollständig abgelöst, d. h. es bleiben keinerlei Reste oder Rückstände der Schicht auf dem Substrat. Die bei der Photolyse gebildeten Säuren führen zu einer effizienten Vernetzung der Resist-Komponenten b) und c), was die Herstellung von hochempfindlichen, negativ arbeitenden Gemischen erlaubt.

Mit den erfindungsgemäßen Gemischen hergestellte Aufzeichnungsmaterialien zeigen eine höchsten Ansprüchen genügende Bilddifferenzierung und eine Verbesserung des Kontrasts und des Auflösungsvermögens. Die erfindungsgemäßen Gemische erlauben beispielsweise die Herstellung eines hochempfindlichen, negativ arbeitenden Photoresists für energiereiche UV2-Strahlung (z. B. 248 nm).

Darüber hinaus lassen sich die Verbindungen des Typs a) auch mit Onium-Salzen, anderen Halogenverbindungen, insbesondere chromophor substituierten Trichlormethyltriazinderivaten oder Trichlormethyloxadiazolderivaten, 1,2-Disulfonen, o-Chinondiazidsulfonylchloriden oder Organometall-Organohalogen-Kombinationen kombinieren. Es kommen aber auch Mischungen mit Bis(sulfonyl)diazomethanen und Sulfonylcarbonyldiazomethanen in Frage. In solchen Gemischen können jedoch die eingangs erwähnten Nachteile wieder auftreten.

Der Anteil an säurebildenden Verbindungen a) im erfindungsgemäßen Gemisch liegt im allgemeinen bei 0,2 bis 10 Gew.-%, bevorzugt bei 0,5 bis 8 Gew.-%, bezogen auf das Gesamtgewicht der Komponenten b) und c).

Als säurevernetzbare Verbindungen b) kommen besonders monomere und oligomere Melamin-Formaldehyd- und Harnstoff-Formaldehyd-Kondensate (EP-A 0 133 216, DE-A 36 34 371, DE 37 11 264) in Betracht.

Bevorzugte Vernetzer sind Melamin/Formaldehyd-Derivate, die zwei bis sechs N-Hydroxymethyl-, N-Alkoxymethyl- oder N-Acyloxymethylgruppen aufweisen. Insbesondere die N-Alkoxymethylderivate sind zum Einsatz in dem erfindungsgemäßen strahlungsempfindlichen Gemisch geeignet. Melaminderivate, die im Durchschnitt mindestens 3, insbesondere mindestens 3,5 Alkoxymethylgruppen enthalten, sind bevorzugt, da dann die Lagerstabilität des erfindungsgemäßen strahlungsempfindlichen Gemischs am besten ist. Die Art des Alkylteils der Alkoxymethylgruppen ist dabei nicht besonders kritisch. Die Melaminderivate können neben Methoxymethylgruppen auch Ethoxymethyl-, Propoxymethyl- oder Butoxymethylgruppen oder deren Mischungen enthalten. Besonders bevorzugt sind jedoch solche Derivate, die ausschließlich Methoxymethylgruppen tragen. Verschiedene Arten von alkoxymethylsubstituierten Melaminen sind im Handel erhältlich. Hier sei besonders auf die Produkte [R]Cymel (Cyanamid Co.), [R]Nicalacs (Sanwa Chemical Co.), [R]Plastopal (BASF AG) oder [R]Maprenal (Hoechst AG) verwiesen.

Die Melaminderivate sind in Lage, bei erhöhten Temperaturen unter dem Einfluß der photolytisch erzeugten Säure mit den polymeren Bindemitteln des Typs c) zu vernetzen. Allgemein sind sie dadurch gekennzeichnet, daß sie unter den nachstehend beschriebenen Temperatur- und Säurebedingungen ein Carbonium-ion bilden können.

Der Anteil der säurevernetzbarem Verbindung b) am erfindungsgemäßen strahlungsempfindlichen Gemisch liegt zweckmäßig bei 5 bis 50 Gew.-%, vorzugsweise bei 10 bis 40 Gew.-%, jeweils bezogen auf das Gesamtgewicht der festen Bestandteile des Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel c). Das Bindemittel zeichnet sich im besonderen dadurch aus, daß es mit den übrigen Bestandteilen des erfindungsgemäßen strahlungsempfindlichen Gemisches gut verträglich ist, im Wellenlängenbereich von 220 bis 280 nm eine möglichst geringe Eigenabsorption, d.h. eine hohe Transparenz, aufweist und in einem wäßrig-alkalischen Entwickler, der 2,38 Gew.-% Tetramethylammoniumhydroxid enthält, bei 21°Cmit einer Rate von 200 bis 3000 nm/min abgetragen wird.

Bevorzugte Bindemittel sind Homo- und Copolymere des 2-, 3- und 4-Hydroxystyrols und der alkylierten 2-, 3- und 4-Hydroxystyrole, insbesondere der alkylierten 4-Hydroxystyrole, z.B. des 3-Methyl-4-hydroxystyrols, des 2,3- und 3,5-Dimethyl-4-hydroxystyrols. Besonders bevorzugt sind Copolymere aus alkylierten und nicht-alkylierten Hydroxystyrolen, wobei der Anteil der nicht-alkylierten Hydroxystyrole vorteilhaft nicht höher als 50 Gew.-% ist. Als Comonomere können jedoch auch Verbindungen wie Styrol und Methyl(meth)acrylat eingesetzt werden. Weiterhin lassen sich Mischungen (Blends) der oben genannter Polymere einsetzen. Blends aus alkylierten und nicht-alkylierten Polyhydroxystyrolen sind wiederum bevorzugt, wobei auch hier der Anteil der nicht alkylierten Polyhydroxystyrole die 50 Gew.-%-Marke möglichst nicht überschreiten sollte. Die Polymeren haben üblicherweise ein Molekulargewicht von 5000 bis 50000 g/mol, bevorzugt von 5000 bis 35000 g/mol.

Die Menge des Bindemittels beträgt im allgemeinen 40 bis 95 Gew.-%, bevorzugt 50 bis 90 Gew.-%, bezogen auf das Gesamtgewicht der festen Anteile des strahlungsempfindlichen Gemisches.

Die Extinktion des Bindemittels bzw. der Kombination von Bindemitteln für Strahlung der Wellenlänge von etwa 220 bis 500 nm sollte weniger als 0,5, bevorzugt weniger als 0,3 $\mu m^{-1}$, betragen.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen $(C_1-C_6)$Carbonsäuren und entweder $(C_1-C_8)$Alkanolen oder $(C_1-C_8)$Alkandiolen oder $(C_1-C_6)$Alkoxy-$(C_1-C_8)$alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, N-Methyl-pyrrolidin-2-on und Butyrolacton sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie Glas oder Indium-Zinnoxid, ferner Metallplatten und -folien - beispielsweise aus Aluminium, Kupfer, Zink-, Bimetall- und Trimetallfolien, aber auch elektrisch nichtleitende Folien, die mit Metallen bedampft sind, und Papier. Diese Substrate können thermisch vorbehandelt, oberflächlich aufgerauht, angeätzt oder zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Der gleiche Effekt läßt sich mit einer haftvermittelnden Zwischenschicht erreichen. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert werden, daneben Zink- und Stahlplatten, die gegebenenfalls verchromt werden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 $\mu$m, bevorzugt zwischen 1 und 10 $\mu$m.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Nach der Bestrahlung wird die Schicht 30 bis 300 s auf eine Temperatur von 90 bis 140ºC erhitzt, um das latente Bild zu sensibilisieren. Danach behandelt man die Schicht mit einer Entwicklerlösung, die die unbestrahlten Bereiche der Schicht löst und entfernt, so daß ein Abbild der bei der bildmäßigen Bestrahlung verwendeten Vorlage auf der Substratoberfläche verbleibt.

Die Erwärmung der Schicht vor der Entwicklung erhöht die Empfindlichkeit des erfindungsgemäßen Aufzeichnungsmaterials und ist für die Herstellung von feinsten Linienmustern wesentlich. Wird der Erwärmungsschritt bei zu niedrigen Temperaturen durchgeführt, so wird keine ausreichende Empfindlichkeit des Materials erzielt. Andererseits können zu hohe Temperaturen zu einer Verschlechterung des Auflösungsvermögens führen.

Als Entwickler eignen sich besonders wäßrige Lösungen, die Silikate, Metasilikate, Hydroxide, Hydrogen- und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler werden in den US-A 4,141,733, 4,628,023, 4,729,941 und sowie den EP-A 0 023 758, 0 062 733 und 0 097 282 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können geringe Mengen eines Netzmittels zugesetzt sein, um die Ablösung der löslichen Bereiche der Schicht zu erleichtern.

Die entwickelten Schichtstrukturen können nachgehärtet werden. Dies geschieht im allgemeinen durch Erhitzen auf einer hot plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen zusätzlich vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht in hoher Dosis erfolgen.

Verwendung findet das erfindungsgemäße strahlungsempfindliche Gemisch bei der Herstellung von integrierten Schaltungen oder von einzelnen elektrischen Bausteinen mit lithographischen Prozessen, da es eine hohe Lichtempfindlichkeit aufweist, besonders bei Bestrahlung mit Licht einer Wellenlänge zwischen 190 bis 300 nm. Da das Gemisch bei Belichtung sehr gut ausbleicht, lassen sich feinere Strukturen erzielen als dies mit den bekannten Gemischen möglich ist. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber keine Einschränkung bewirken. Gt steht im Folgenden für Gewichtsteile, Vt für Volumenteile. Gt verhalten sich zu Vt wie g zu cm$^3$.

Die erfindungsgemäßen strahlungsempfindlichen Gemische und ihre Verwendung als Aufzeichnungsmaterialien werden wie folgt untersucht und mit vorbeschriebenen Gemischen verglichen:

1. Bestimmung der Empfindlichkeit gegenüber der UV-Strahlung einer Breitbandlichtquelle, wobei der Lichtquelle ein Filter vorgesetzt ist, das Strahlung einer Wellenlänge von 240 bis 260 nm durchläßt, sowie gegenüber der Strahlung eines KrF-Eximer-Lasers, der bei 248 nm emittiert. Als Maß für die Empfindlichkeit wird die kleinste Bestrahlungsdosis (in mJ/cm$^2$), die zur Herstellung eines Restfilmverhältnisses von 0,8 in den bestrahlten Bereichen erforderlich ist, angegeben. Das Restfilmverhältnis ist definiert als der Quotient aus der Filmschichtdicke nach und vor der Entwicklung.

2. Bestimmung der Entwickelbarkeit mit einem wäßrig-alkalischen Entwickler, der 2,38 Gew.-% Tetramethylammoniumhydroxid enthält und 120 s auf das Gemisch einwirkt. Dabei wird zwischen folgenden Ergebnissen bei der Entwicklung von Graben- und Linienmustern mit einem Abstand von 0,4 μm unterschieden:

A) vollständige Ablösung der Resistschicht in den unbelichteten Bereichen und höchstens 20%ige Verminderung der Filmschichtdicke in den belichteten Bereichen,

B) vollständige Ablösung der Resistschicht in den unbelichteten Bereichen und mehr als 20%ige Verminderung der Filmschichtdicke in den belichteten Bereichen,

C) unvollständige Ablösung der Resistschicht in den unbelichteten Bereichen.

3. Bestimmung der Querschnittsform der Linienmuster durch Untersuchung mit einem Rasterelektronenmikroskop. Dabei wird zwischen den Formen D) bis G) unterschieden:

D) orthogonale Flanken und eine höchstens leicht gerundete Schulter,

E) unterschnittene Flanken,

F) trapezoider Querschnitt und

G) trapezoider Querschnitt mit sogenannten Schleppkanten

4. Bestimmung der Lagerstabilität H) bis I) der Lösung des Aufzeichnungsmaterials:

H) nach 120tägiger Lagerung bei Raumtemperatur keinerlei Bildung von sichtbaren Niederschlägen und Abweichungen in der Empfindlichkeit < 5% gegenüber der ursprünglich eingestellten Empfindlichkeit,

I) nach 120tägiger Lagerung sichtbare Niederschläge und/oder eine Abweichung in der Empfindlichkeit > 5% gegenüber der ursprünglich eingestellten Empfindlichkeit.

5. Bestimmung der Linearität K) bis M) des Materials: Die Belichtungsdosis wurde so gewählt, daß 1,0 μm breite Gräben und Linien im Maßstab 1 : 1 wiedergegeben wurden. Dann wurden 0,4 μm breite Gräben und Linien bei der gleichen Dosis vermessen:

K) die Abweichung von der Maske betrug < 5%,

L) die Abweichung von der Maske betrug < 10%,

M) die Abweichung von der Maske betrug > 10%.

Beispiel 1

Es wurde ein Homopolymer aus 3-Methyl-4-hydroxystyrol mit einem mittleren Molekulargewicht von 20.000 und einer Glasübergangstemperatur von 135°C unter Verwendung von Azobisisobutyronitril als Polymerisationsinitiator hergestellt. Die Abtragsrate eines Films aus reinem Polymer in einem wäßrig-alkalischen Entwickler, der 2,38 % Tetramethylammoniumhydroxid enthielt, betrug 350 nm/min.

Es wurde eine Beschichtungslösung hergestellt aus

| | |
|---|---|
| 7,7 Gt | des oben beschriebenen Polymers, |
| 2,3 Gt | Hexa-N-methoxymethyl-melamin und |
| 0,2 Gt | Tribrommethyl-phenyl-sulfon in |
| 42 Gt | Propylenglykol-monomethylether-acetat. |

Die Lösung wurde durch ein Filter mit einem Porendurchmesser von 0,1 $\mu$m filtriert und in zwei gleiche Teile geteilt. Während der eine Teil 120 Tage bei Raumtemperatur (21°C) gelagert und erst dann in nachstehend beschriebener Weise weiterverarbeitet wurde, wurde der zweite Teil gleich nach der Filtration auf einen mit einem Haftvermittler (Hexamethyldisilazan) behandelten Wafer bei 3.000 Umdrehungen aufgeschleudert. Nach 1 min Trocknen bei 100°C auf der hot plate betrug die Schichtdicke 1,02 $\mu$m.

Das Aufzeichnungsmaterial wurde bildmäßig unter einer Vorlage mit einem KrF-Excimer-Laser und einer Energie von 15 mJ/cm$^2$ belichtet, nach kurzer Lagerung 1 min auf 105°Cnacherwärmt und anschließend durch Eintauchen in eine wäßrige Entwicklerlösung, die 2,38 Gew.-% Tetramethylammoniumhydroxid enthielt, bei 21°C verarbeitet. Nach einer Entwicklungsdauer von 120 s erhielt man ein fehlerfreies Abbild der Maske (A) mit hoher Flankenstabilität (D), wobei Strukturen < 0,35 $\mu$m detailgetreu aufgelöst waren und das Breitenverhältnis (Linearität des Resists) nominal gleicher Linien/Gräbenstrukturen im Bereich zwischen 1 $\mu$m und 0,4 $\mu$m praktisch konstant war (K). Der zweite Teil der Lösung wurde vor der Weiterverarbeitung auf Ausfällungen untersucht (H) und dann filtriert. Das gelagerte Material hatte ebenfalls eine Empfindlichkeit von 15 mJ/cm$^2$.

Beispiel 2

Es wurde eine Beschichtungslösung hergestellt aus

| | |
|---|---|
| 7,5 Gt | eines Copolymeren aus 3-Methyl-4-hydroxystyrol/4-Hydroxystyrol (Molverhältnis 85:15) mit einem mittleren Molekulargewicht von 22.000, |
| 2,5 Gt | Hexa-N-methoxymethyl-melamin und |
| 0,4 Gt | Tribrommethyl-phenyl-sulfon in |
| 42 Gt | Propylenglykol-monomethylether-acetat. |

Die Lösung wurde durch ein Filter mit einem Porendurchmesser von 0,1 $\mu$m filtriert und auf einen mit einem Haftvermittler (Hexamethyldisilazan) behandelten Wafer bei 3.000 Umdrehungen aufgeschleudert. Nach 1 min Trocknen bei 90°C auf der hot plate betrug die Schichtdicke 1,06 $\mu$m.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 5 mJ/cm$^2$ belichtet, nach kurzer Lagerung 90 s auf 110°C nacherwärmt und anschließend mit dem in Beispiel 1 beschriebenen Entwickler verarbeitet.

Nach einer Entwicklungsdauer von 120 s erhielt man ein fehlerfreies Abbild der Maske (A) mit hoher Flankenstabilität (D), wobei auch hier Strukturen < 0,35 $\mu$m detailgetreu aufgelöst waren. Die Haltbarkeit der Lösung wurde mit (H) eingestuft.

Beispiel 3

Es wurde eine Beschichtungslösung hergestellt aus

| | |
|---|---|
| 6,5 Gt | des in Beispiel 1 beschriebenen Homopolymerisats, |
| 1,0 Gt | eines Homopolymerisats aus 4-Hydroxystyrol (Hoechst Celanese Corp.), |
| 2,5 Gt | Hexa-N-methoxymethyl-melamin und |
| 0,4 Gt | Tribrommethylphenylsulfon in |
| 42 Gt | Propylenglykol-monomethylether-acetat. |

Die Lösung wurde durch ein Filter mit einem Porendurchmesser von 0,1 $\mu$m filtriert und auf einen mit einem Haftvermittler (Hexamethyldisilazan) behandelten Wafer bei 3.000 Umdrehungen aufgeschleudert. Nach 1 min Trocknen bei 110°C auf der hot plate betrug die Schichtdicke 1,03 $\mu$m.

Das Aufzeichnungsmaterial wurde bildmäßig unter einer Vorlage mit einer Xenon-Quecksilberdampflampe unter Verwendung eines Interferenzfilters mit Strahlung von 248 ± 10 nm und einer Energie von 4 mJ/cm² belichtet, nach kurzer Lagerung 90 s auf 110°C nacherwärmt und anschließend mit dem in Beispiel 1 beschriebenen Entwickler verarbeitet.

Nach einer Entwicklungsdauer von 120 s erhielt man ein fehlerfreies Abbild der Maske (A) mit hoher Flankenstabilität (D), wobei auch hier Strukturen < 0,35 μm detailgetreu aufgelöst waren. Die Haltbarkeit der Lösung wurde ebenfalls mit (H) eingestuft.

Beispiele 4 bis 39 und Vergleichsbeispiele 40 bis 52

Die Verfahrensweise jedes dieser Beispiele erfolgte im wesentlichen gemäß Beispiel 1 mit folgenden Unterschieden: die Art und Menge der Zusammensetzung und das Molekulargewicht der Polymeren, die Art und Menge des Melaminvernetzers, ihr Masseverhältnisses zueinander und die Art und Menge des Starters wie in Tabelle 2 angegeben.

In Tabelle 1 sind verschiedene Polymertypen beschrieben, wobei H für Homopolymer, C für Copolymer und B für Blend (Mischungen von Polymeren) steht. Die weiteren Abkürzungen haben folgende Bedeutungen:

| | |
|---|---|
| 2HS = | 2-Hydroxystyrol, |
| 3HS = | 3-Hydroxystyrol, |
| 4HS = | 4-Hydroxystyrol, |
| 3Me4HS = | 3-Methyl-4-hydroxystyrol, |
| 2,3DMe4HS = | 2,3-Dimethyl-4-hydroxystyrol, |
| 3,5DMe4HS = | 3,5-Dimethyl-4-hydroxystyrol, |
| St = | Styrol. |
| M1 = | ein methoxymethyliertes Melamin mit einem mittleren Methoxymethylierungsgrad > 5,5, |
| M2 = | ein methoxymethyliertes Melamin mit einem mittleren Methoxymethylierungsgrad von 3,5, |
| M3 = | ein methoxymethyliertes Melamin mit einem mittleren Methoxymethylierungsgrad von 2,5, |
| M4 = | ein butoxymethyliertes Melamin mit einem mittleren Butoxymethylierungsgrad > 5,5. |
| T1 = | Tribrommethyl-phenyl-sulfon, |
| T2 = | Tribrommethyl-(4-chlorphenyl)-sulfon, |
| S1 = | 4,6-Bis-(trichloromethyl)-2-(4-methoxyphenyl)-[1,3,5]triazin, |
| S2 = | 1,1-Bis-(4-chlorphenyl)-2,2,2-trichlorethan (EP-A 0 232 972), und |
| S3 = | Bis-(4-t-Butyl-phenylsulfonyl)diazomethan. |

Tabelle I

| Polymer | Typ | Verhältnis | Molekülmasse |
|---|---|---|---|
| 1 | H 2HS | 100 | 10000 |
| 2 | H 3Me4HS | 100 | 8000 |
| 3 | H 3Me4HS | 100 | 15000 |
| 4 | H 3Me4HS | 100 | 30000 |
| 5 | H 2,3DMe4HS | 100 | 9000 |
| 6 | H 3,5DMe4HS | 100 | 12000 |
| 7 | C 2HS/4HS | 85 : 15 | 12000 |
| 8 | C 3Me4HS/4HS | 95 : 5 | 18000 |
| 9 | C 3Me4HS/4HS | 90 : 10 | 15000 |
| 10 | C 3Me4HS/4HS | 90 : 10 | 22000 |
| 11 | C 3Me4HS/4HS | 80 : 20 | 22000 |
| 12 | C 3Me4HS/3HS | 85 : 15 | 20000 |
| 13 | C 2,3DMe4HS/4HS | 85 : 15 | 12000 |
| 14 | C 3,5DMe4HS/4HS | 80 : 20 | 14000 |
| 15 | B 2HS/4HS | 80 : 20 | 10000/20000 |
| 16 | B 3Me4HS/4HS | 95 : 5 | 22000/20000 |
| 17 | B 3Me4HS/4HS | 90 : 10 | 22000/20000 |
| 18 | B 3Me4HS/4HS | 80 : 20 | 22000/20000 |
| 19 | B 3Me4HS/3HS | 85 : 15 | 22000/20000 |
| 20 | B 2,3DMe4HS/4HS | 85 : 15 | 9000/20000 |
| 21 | B 3,5DMe4HS/4HS | 80 : 20 | 12000/20000 |
| 22 | H 4HS | 100 | 20000 |
| 23 | C 4HS/ST | 80 : 20 | 25000 |
| 24 | C 2HS/4HS | 20 : 80 | 16000 |
| 25 | C 3HS/4HS | 40 : 60 | 16000 |

## Tabelle II

| Beispiel | Polymer | Melamin | Verhältnis | Starter |
|---|---|---|---|---|
| 4 | 1 | M1 | 75 : 25 | T1 3% |
| 5 | 2 | M1 | 90 : 10 | T1 2% |
| 6 | 2 | M1 | 80 : 20 | T1 2% |
| 7 | 2 | M1 | 80 : 20 | T1 4% |
| 8 | 2 | M2 | 80 : 20 | T1 2% |
| 9 | 2 | M3 | 80 : 20 | T1 2% |
| 10 | 2 | M4 | 80 : 20 | T1 2% |
| 11 | 3 | M1 | 80 : 20 | T1 2% |
| 12 | 4 | M1 | 80 : 20 | T1 2% |
| 13 | 5 | M1 | 80 : 20 | T1 2% |
| 14 | 6 | M1 | 80 : 20 | T1 2% |
| 15 | 7 | M1 | 80 : 20 | T1 2% |
| 16 | 8 | M1 | 85 : 15 | T1 2% |
| 17 | 8 | M1 | 75 : 25 | T1 2% |
| 18 | 8 | M1 | 80 : 20 | T1 4% |
| 19 | 9 | M1 | 80 : 20 | T1 2% |
| 20 | 9 | M2 | 80 : 20 | T1 2% |
| 21 | 10 | M1 | 80 : 20 | T1 2% |
| 22 | 10 | M2 | 80 : 20 | T1 2% |
| 23 | 11 | M1 | 80 : 20 | T1 2% |
| 24 | 12 | M1 | 80 : 20 | T1 2% |
| 25 | 13 | M1 | 80 : 20 | T1 4% |
| 26 | 14 | M1 | 80 : 20 | T1 2% |
| 27 | 15 | M2 | 80 : 20 | T1 2% |
| 28 | 16 | M1 | 80 : 20 | T1 2% |
| 29 | 16 | M2 | 80 : 20 | T1 2% |
| 30 | 17 | M1 | 75 : 25 | T1 2% |
| 31 | 17 | M1 | 80 : 20 | T1 2% |
| 32 | 17 | M2 | 80 : 20 | T1 2% |
| 33 | 17 | M1 | 80 : 20 | T1 4% |

## Tabelle II, Fortsetzung 1

| Beispiel | Polymer | Melamin | Verhältnis | Starter |
|---|---|---|---|---|
| 34 | 17 | M2 | 80 : 20 | T1 4% |
| 35 | 18 | M1 | 80 : 20 | T1 4% |
| 36 | 18 | M1 | 80 : 20 | T1 2% |
| 37 | 19 | M1 | 80 : 20 | T1 2% |
| 38 | 20 | M2 | 80 : 20 | T1 2% |
| 39 | 21 | M2 | 80 : 20 | T1 2% |
| Vergleichsbeispiele | | | | |
| 40 | 3 | M1 | 80 : 20 | S1 2% |
| 41 | 3 | M1 | 80 : 20 | S2 2% |
| 42 | 3 | M1 | 80 : 20 | S3 2% |
| 43 | 3 | M4 | 80 : 20 | S3 2% |
| 44 | 22 | M1 | 80 : 20 | T1 2% |
| 45 | 22 | M1 | 80 : 20 | T1 4% |
| 46 | 22 | M1 | 80 : 20 | S1 4% |
| 47 | 22 | M1 | 80 : 20 | S2 4% |
| 48 | 22 | M2 | 80 : 20 | T1 4% |
| 49 | 22 | M4 | 80 : 20 | T1 4% |
| 50 | 22 | M3 | 80 : 20 | T1 2% |
| 51 | 23 | M1 | 80 : 20 | T1 2% |
| 52 | 24 | M1 | 80 : 20 | T1 2% |

In Tabelle 3 sind die beobachteten Untersuchungsergebnisse der strahlungsempfindlichen Gemische der oben beschriebenen Beispiele zusammengefaßt. In dieser Tabelle haben die Abkürzungen folgende Bedeutungen:

Bsp. = Beispiel Nr.
Emp. = Empfindlichkeit in mJ/cm$^2$ (Lambda Physics KrF Excimer Laser),
ReF. = Restfilmdicke nach Entwicklung in %,
Ent. = die Art der Entwicklung,
QsF. = Querschnittsform der verbliebenen Linie (0,4 $\mu$m),
LSt. = Lagerstabilität,
Lin. = Linearität.

## Tabelle III

| Bsp. | Emp. | ReF. | Ent. | QsF. | LSt. | Lin. |
|------|------|------|------|------|------|------|
| 4 | 12 | 94 | A | D | H | L |
| 5 | 35 | 90 | A | D | H | K |
| 6 | 20 | 92 | A | D | H | K |
| 7 | 5 | 92 | A | D | H | K |
| 8 | 22 | 94 | A | D | H | K |
| 9 | 22 | 85 | A | F | H | L |
| 10 | 25 | 82 | A | F | I | L |
| 11 | 20 | 90 | A | D | H | K |
| 12 | 18 | 90 | A | D | H | K |
| 13 | 22 | 87 | A | F | H | L |
| 14 | 25 | 86 | A | F | H | L |
| 15 | 32 | 92 | A | F | – | L |
| 16 | 21 | 87 | A | F | H | L |
| 17 | 24 | 92 | A | D | H | K |
| 18 | 5 | 91 | A | D | H | K |
| 19 | 18 | 94 | A | D | H | K |
| 20 | 18 | 92 | A | D | H | K |
| 21 | 16 | 89 | A | F | H | L |
| 22 | 16 | 88 | A | F | H | L |
| 23 | 15 | 92 | A | G | H | L |
| 24 | 20 | 87 | A | F | H | L |
| 25 | 7 | 92 | A | F | H | L |

## Tabelle III, Fortsetzung

| Bsp. | Emp. | ReF. | Ent. | QsF. | LSt. | Lin. |
|------|------|------|------|------|------|------|
| 26 | 32 | 86 | A | F | H | L |
| 27 | 19 | 91 | A | E | H | L |
| 28 | 18 | 92 | A | E | H | L |
| 29 | 18 | 95 | A | D | H | K |
| 30 | 20 | 95 | A | D | H | K |
| 31 | 18 | 93 | A | D | H | K |
| 32 | 18 | 92 | A | D | H | K |
| 33 | 8 | 90 | A | D | H | K |
| 34 | 9 | 92 | A | D | H | K |
| 35 | 6 | 89 | A | D | H | K |
| 36 | 15 | 90 | A | D | H | K |
| 37 | 20 | 85 | A | F | H | L |
| 38 | 23 | 88 | A | F | H | L |
| 39 | 18 | 89 | A | F | H | L |
| Vergleichsbeispiele | | | | | | |
| 40 | 20 | 85 | C | G | H | L |
| 41 | 34 | 89 | A | G | H | L |
| 42 | 55 | 90 | C | G | H | L |
| 43 | 60 | 87 | C | G | I | M |
| 44 | 14 | 56 | B | E | H | M |
| 45 | 6 | 87 | B | E | H | M |
| 46 | 10 | 86 | B | E | H | M |
| 47 | 8 | 84 | B | E | H | M |
| 48 | 7 | 87 | B | E | H | M |
| 49 | 11 | 82 | B | E | I | M |
| 50 | 25 | 78 | B | E | H | M |
| 51 | 15 | 96 | C | G | H | M |
| 52 | 18 | 91 | B | E | H | M |

**Patentansprüche**

1. Negativ arbeitendes strahlungsempfindliches Gemisch mit

a) einer Verbindung, die mindestens eine -CBr$_3$ Gruppe, gebunden an ein Atom, das nicht seinerseits mit einem Wasserstoffatom verbunden ist, enthält und unter Einwirkung aktinischer Strahlung starke Säure bildet,

b) einer Verbindung mit mindestens zwei durch Säure vernetzbaren Gruppen und

c) einem in Wasser unlöslichen, in wäßrig-alkalischen Lösungen löslichen oder zumindest quellbaren polymeren Bindemittel mit phenolischen OH-Gruppen,

dadurch gekennzeichnet, daß

(1) es bei 248 nm eine Absorption $< 0{,}4\ \mu m^{-1}$ aufweist,

(2) die CBr$_3$-Gruppe der Verbindung a) an das Schwefelatom einer Sulfonylgruppe gebunden und die Verbindung a) in einer Menge von 0,2 bis 10 Gew.-%, bezogen auf die Gesamtmenge der Komponenten b) und c), im Gemisch enthalten ist,

(3) das Massenverhältnis der Komponenten b) und c) zwischen 50 : 50 und 5 : 95 liegt und

(4) die Komponente c) ein Homo- oder Copolymer des Hydroxystyrols oder eines Derivats davon ist, wobei das Homo- oder Copolymer in einem wäßrigalkalischen, 2,38 Gew.-% Tetramethylammoniumhydroxid enthaltenden Entwickler bei 21°C eine Abtragsrate von 200 bis 3000 nm/min aufweist.

2. Negativ arbeitendes strahlungsempfindliches Gemisch gemäß Anspruch 1, dadurch gekennzeichnet daß die Verbindung a) aus der Gruppe der Tribrommethyl-arylsulfone ausgewählt ist.

3. Negativ arbeitendes strahlungsempfindliches Gemisch gemäß Anspruch 2, dadurch gekennzeichnet daß das Tribrommethyl-aryl-sulfon Tribrommethyl-phenyl-sulfon ist.

4. Negativ arbeitendes strahlungsempfindliches Gemisch gemäß Anspruch 1, dadurch gekennzeichnet daß die Verbindung b) ein alkoxymethyliertes oder acyloxymethyliertes Melamin ist.

5. Negativ arbeitendes strahlungsempfindliches Gemisch gemäß Anspruch 4, dadurch gekennzeichnet daß das alkoxymethylierte Melamin mindestens 3, bevorzugt mindestens 3,5 Alkoxymethylgruppen enthält.

6. Negativ arbeitendes strahlungsempfindliches Gemisch gemäß Anspruch 1, dadurch gekennzeichnet daß das alkoxymethylierte Melamin ein methoxymethyliertes Melamin ist.

7. Negativ arbeitendes strahlungsempfindliches Gemisch gemäß Anspruch 1, dadurch gekennzeichnet daß die Komponente c) ein alkyliertes Polyhydroxystyrol ist.

8. Negativ arbeitendes strahlungsempfindliches Gemisch gemäß Anspruch 7, dadurch gekennzeichnet daß die Komponente c) ein Copolymer ist.

9. Negativ arbeitendes strahlungsempfindliches Gemisch gemäß Anspruch 1, dadurch gekennzeichnet daß die Komponente c) ein Blend aus einem alkylierten und einem nicht alkylierten Polyhydroxystyrol ist.

10. Strahlungsempfindliches Aufzeichnungsmaterial bestehend aus einem Substrat und einer darauf befindlichen strahlungsempfindlichen Schicht, dadurch gekennzeichnet, daß die strahlungsempfindliche Schicht aus einem strahlungsempfindlichen Gemisch gemäß einem oder mehreren der Ansprüche 1 bis 9 besteht.

| | | |
|---|---|---|
| **Europäisches Patentamt** | **EUROPÄISCHER RECHERCHENBERICHT** | **Nummer der Anmeldung**<br><br>EP 92 11 2559 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| P,X | EP-A-0 458 325 (MITSUBISHI KASEI CORPORATION)<br>* Seite 12, Zeile 28 - Zeile 34; Beispiel 26 *<br><br>--- | 1-10 | G03F7/029 |
| Y,D | EP-A-0 232 972 (ROHM AND HAAS COMPANY)<br>* Seite 6, Zeile 36 - Zeile 41; Anspruch 4 *<br><br>--- | 1-10 | |
| Y | EP-A-0 374 856 (OKI ELECTRIC INDUSTRY CO./FUJI CHEMICALS INDUSTRIAL CO.)<br>* Seite 9, Zeile 1 - Zeile 30 *<br>* Seite 12, Zeile 1 - Zeile 14 *<br><br>----- | 1-10 | |
| | | | **RECHERCHIERTE SACHGEBIETE (Int. Cl.5 )**<br><br>G03F |

Der vorliegende Recherchenbericht wurde für alle Patentansprüche erstellt

| Recherchenort | Abschlußdatum der Recherche | Prüfer |
|---|---|---|
| DEN HAAG | 20 OKTOBER 1992 | DUPART J-M.B. |